# EUROPEAN PATENT APPLICATION

(11) **EP 2 641 997 A1**
(43) Date of publication of application: **25.09.2013**
(21) Application number: 11842434.0
(22) Date of filing: 17.11.2011
(51) Int. Cl.: C23C 24/04, B32B 18/00, H01L 23/36, H05K 1/03, H05K 3/38

(54) **LAMINATE AND METHOD FOR PRODUCING LAMINATE**

(30) Priority: 19.11.2010 JP 2010259412
(71) Applicant: NHK Spring Co., Ltd., Yokohama-shi, Kanagawa 236-0004 (JP)
(72) Inventor: YAMAUCHI, Yuichiro, Yokohama-shi Kanagawa 236-0004 (JP); SAITO, Shinji, Yokohama-shi Kanagawa 236-0004 (JP); AKABAYASHI, Masaru, Yokohama-shi Kanagawa 236-0004 (JP); HIRANO, Satoshi, Isehara-shi Kanagawa 259-1126 (JP)
(74) Representative: HOFFMANN EITLE
(86) International application number: PCT/JP2011/077115
(87) International publication number: WO 2012/067263

(57) **Abstract**

It is possible to obtain a laminate having high adhesion strength between ceramic and a metal coating by providing the following: an insulating ceramic substrate (10); an intermediate layer (50) formed on the surface of the ceramic substrate (10) and having a metal-containing principal component metal layer (51) and an active ingredient layer (52) including metal, a metal oxide, or a metal hydride; and a metal coating (40) formed on the surface of the intermediate layer (50) by accelerating a metal-containing powder with gas, and depositing the same on the surface thereof by spraying while in a solid state.

## Description

### Field

The present invention relates to a laminate used between electric circuit boards and the like, and a method of manufacturing the laminate.

### Background

Conventionally, a power module has been included in examples of an energy saving key device in a wide range of areas from an industrial and automotive power control to motor control. The power module includes a temperature controller (cooler or heater) in which a transfer pathway of a heating medium for cooling or heating is formed through an insulating substrate serving as a substrate.
For example, a laminate including a metal coating formed on a ceramic substrate which is an insulating substrate is used in the temperature controller. When the temperature-control device is used, the power module may be cooled down by moving heat generated from a chip (transistor) stacked on a surface of the insulating substrate where the temperature controller is not formed to the metal coating, and radiating the heat to the outside. A circuit pattern using a metal coating is formed between the insulating substrate and the chip, and a laminate including a metal coating formed on a ceramic substrate is also used in this part.

Incidentally, in the laminate described above, high adhesion strength is desired between the ceramic substrate and the metal coating. Examples of a method of forming a metal coating on a ceramic substrate include a flame coating method and a cold spray method. The flame coating method is a method of forming a coating by spraying a substrate with a flame coating material heated to a molten state or an almost molten state.

On the other hand, the cold spray method is a method of forming a coating on a surface of a substrate by spraying powder of a material for a coating from a convergent-divergent (Laval) nozzle together with an inert gas in a state corresponding to a melting point or softening point or less, and causing the material for a coating to collide with the substrate in a solid state (for example, see Patent Literature 1). The cold spray method may obtain a metal coating which excludes a phase transformation and in which oxidation is suppressed since an influence of thermal stress is relieved due to a low temperature when compared to the flame coating method. In particular, when both the substrate and the material for a coating are metal, and powder to be a coating collides with the substrate, plastic deformation occurs between the powder and the substrate, and anchor effect may be obtained. In addition, when the powder collides with the substrate in an area where plastic deformation occurs, a mutual oxide coating is destroyed, and a metallic bond due to newly-formed surfaces occurs, thereby expecting an effect of acquiting a laminate having high adhesion strength.

### Citation List

### Patent Literature

Patent Literature 1: US Patent No. 5,302,414 Summary

### Technical Problem

However, when a substrate is ceramic, and powder to be a coating is metal in the cold spray method disclosed in Patent Literature 1, plastic deformation occurs only on a side of metal, and a sufficient anchor effect is not acquired between ceramic and metal, and thus there is a problem that a laminate having low adhesion strength between ceramic and a metal coating is formed.

The invention is made in view of the above problem, and an object of the invention is to provide a laminate having high adhesion strength between ceramic and a metal coating when manufacturing a laminate obtained by forming a metal coating on a ceramic substrate using a cold spray method, and a method of manufacturing the laminate. Solution to Problem

To solve the problem described above and achieve the object, a laminate according to the present invention includes: an insulating ceramic substrate; an intermediate layer formed on a surface of the ceramic substrate and including a principal component metal layer containing metal and an active ingredient layer including metal, a metal oxide, or a metal hydride; and a metal coating formed on a surface of the intermediate layer by accelerating a metal-containing powder with gas, and depositing the same on the surface thereof by spraying while in a solid state.

Moreover, in the laminate described above, the intermediate layer is formed by a heat treatment in a vacuum.

Moreover, in the laminate described above, the active ingredient layer contains at least one selected from a group consisting of one of metals of titanium, zirconium, hafnium, and germanium, or a metal hydride.

Moreover, in the laminate described above, the principal component metal layer contains at least one selected from a group consisting of gold, silver, copper, aluminum, and nickel.

Moreover, in the laminate described above, the intermediate layer is formed by a heat treatment in the atmosphere.

Moreover, in the laminate described above, the active ingredient layer contains at least one selected from a group consisting of titanium, zirconium, hafnium, germanium, boron, silicon, aluminum, chrome, indium, a metal oxide, and a metal hydride.

Moreover, in the laminate described above, the principal component metal layer contains at least one of gold and silver.

Moreover, a method of manufacturing a laminate according to the present invention is a method in which a metal coating is formed on a surface of a ceramic substrate, and includes: a brazing filler metal disposing step of disposing brazing filler metal containing metal, or a metal oxide or hydride on the surface of the ceramic substrate; an intermediate layer forming step of forming an intermediate layer by performing a heat treatment on the ceramic substrate where the brazing filler metal is disposed in the brazing filler metal disposing step; and a metal coating forming step of forming a metal coating on a surface of the intermediate layer, which is formed by the intermediate layer forming step, by accelerating a metal-containing powder with gas, and depositing the same on the surface thereof by spraying while in a solid state.

Moreover, in the method of manufacturing a laminate described above, the intermediate layer forming step is performed in a vacuum.

Moreover, in the method of manufacturing a laminate described above, the intermediate layer forming step is performed in the atmosphere.

### Advantageous Effects of Invention

A laminate and a method of manufacturing the laminate according to the invention forms an intermediate layer including a principal component metal layer and an active ingredient layer between a ceramic substrate and a metal coating, combines the principal component metal layer with the metal coating, and combines the active ingredient layer with the ceramic substrate. Thus, it is advantageous in that a laminate having high adhesion strength between ceramic and a metal coating may be acquired when a metal coating is formed on a ceramic substrate using a cold spray method.

### Brief Description of Drawings

FIG. 1 is a schematic diagram illustrating a configuration of a power module according to an embodiment of the invention.
FIG. 2 is a cross-sectional view illustrating a configuration of a principal part of the power module illustrated in FIG. 1.
FIG. 3 is a cross-sectional view schematically illustrating a configuration of a principal part of the power module according to the embodiment of the invention.
FIG. 4 is a cross-sectional view schematically illustrating a configuration of a principal part of the power module according to the embodiment of the invention.
FIG. 5 is a schematic diagram illustrating an outline of a cold spray apparatus used for manufacturing the power module according to the embodiment of the invention.
FIG. 6 is a schematic diagram illustrating an example of a configuration of a conventional power module not using a cold spray method.
FIG. 7 is a diagram illustrating a cross-section backscattered electron image of a laminate according to Example 1 of the invention.
FIG. 8 is a diagram illustrating a cross-section backscattered electron image of the laminate according to Example 1 of the invention.
FIG. 9 is a diagram illustrating a cross-section backscattered electron image of the laminate according to Example 1 of the invention.
FIG. 10 is a diagram illustrating a cross-section backscattered electron image of the laminate according to Example 1 of the invention.
FIG. 11 is a diagram illustrating a cross-section backscattered electron image of the laminate according to Example 1 of the invention.
FIG. 12 is a diagram illustrating a result of cross-section element distribution analysis of the cross-section backscattered electron image illustrated in FIG. 11.
FIG. 13 is a diagram illustrating a result of cross-section element distribution analysis of the cross-section backscattered electron image illustrated in FIG. 11.
FIG. 14 is a diagram illustrating a result of cross-section element distribution analysis of the cross-section backscattered electron image illustrated in FIG. 11.
FIG. 15 is a diagram illustrating a result of cross-section element distribution analysis of the cross-section backscattered electron image illustrated in FIG. 11.
FIG. 16 is a diagram illustrating a result of cross-section element distribution analysis of the cross-section backscattered electron image illustrated in FIG. 11.
FIG. 17 is a schematic diagram illustrating a schematic configuration of an evaluation apparatus conducting an adhesion strength evaluation.
FIG. 18 is a diagram illustrating a cross-section backscattered electron image of a laminate according to Example 2 of the invention.
FIG. 19 is a diagram illustrating a cross-section backscattered electron image of a laminate according to Example 3 of the invention.
FIG. 20 is a diagram illustrating a cross-section backscattered electron image of the laminate according to Example 3 of the invention.
FIG. 21 is a diagram illustrating a result of cross-section element distribution analysis of the cross-section backscattered electron image illustrated in FIG. 20.
FIG. 22 is a diagram illustrating a result of cross-section element distribution analysis of the cross-section backscattered electron image illustrated in FIG. 20.
FIG. 23 is a diagram illustrating a result of cross-section element distribution analysis of the cross-section backscattered electron image illustrated in FIG. 20.
FIG. 24 is a diagram illustrating a result of cross-section element distribution analysis of the cross-section backscattered electron image illustrated in FIG. 20.
FIG. 25 is a diagram illustrating a result of cross-section element distribution analysis of the cross-section backscattered electron image illustrated in FIG. 20.
FIG. 26 is a diagram illustrating a cross-section backscattered electron image of a laminate according to Example 4 of the invention.
FIG. 27 is a diagram illustrating a cross-section backscattered electron image of a laminate according to Comparative Example 1 of the invention.
FIG. 28 is a diagram illustrating a cross-section backscattered electron image of a laminate according to Comparative Example 2 of the invention.

### Description of Embodiments

Hereinafter, an embodiment for implementing the invention will be described in detail with reference to drawings. It should be noted that the invention is not limited to the embodiment below. In addition, each drawing referred to in description below merely schematically illustrates a shape, a size, and a positional relation to help understand content of the invention. That is, the invention is not limited to only a shape, a size, and a positional relation illustrated in each drawing.

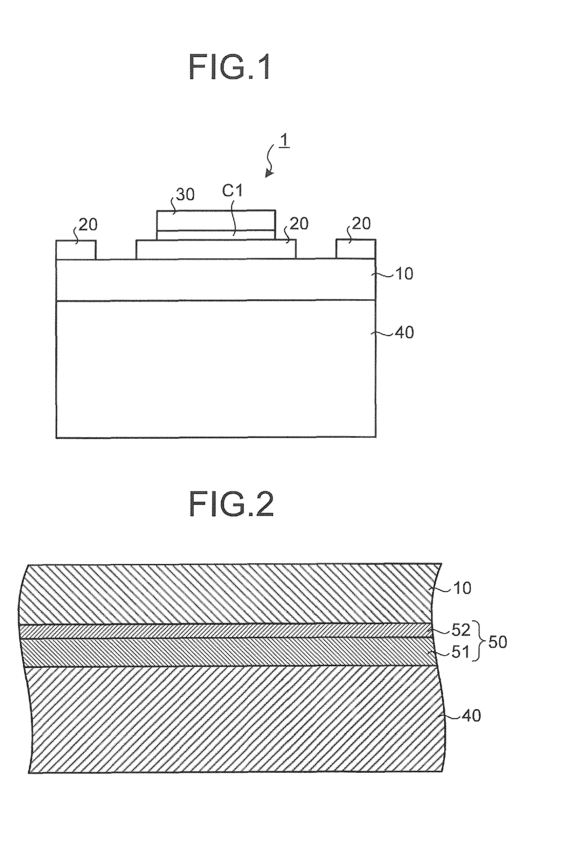

First, a laminate according to the embodiment of the invention will be described in detail with reference to drawings. In description below, a power module will be described as an example of the laminate. FIG. 1 is a schematic diagram illustrating a configuration of a power module according the embodiment of the invention. FIG. 2 is a cross-sectional view illustrating a configuration of a principal part of the power module illustrated in FIG. 1.

A power module 1 includes a ceramic substrate 10 which is an insulating substrate, a copper circuit 20 stacked on the ceramic substrate 10, a chip 30 which is stacked on the copper circuit 20 and is fixed by a solder C1, a cooling fin 40 which is made from a metal coating such as aluminum and is stacked on a surface of the ceramic substrate 10 different from a surface where the copper circuit 20 is stacked.

The ceramic substrate 10 forms substantially a plate-like shape, and includes an insulating member. Examples of the insulating member include an oxide of alumina, magnesia, zirconia, steatite, forsterite, mullite, titania, silica, sialon, and the like, aluminum nitride, silicon nitride, silicon carbide.

The copper circuit 20 forms a circuit pattern used for transferring an electrical signal to the stacked chip 30 by being patterned using copper on a surface of the ceramic substrate 10.

The chip 30 is realized by a semiconductor device such as a diode, a transistor, an IGBT (insulated gate bipolar transistor). A plurality of chips 30 are provided on the ceramic substrate 10 according to the purpose of use.

The cooling fin 40 is a metal coating stacked on a surface of the ceramic substrate 10 by a cold spray method described below. Examples of the metal coating include copper, a copper alloy, aluminum, an aluminum alloy, silver, and a silver alloy. Heat generated from the chip 30 is discharged to the outside through the ceramic substrate 10 by the metal coating.

An intermediate layer 50 illustrated in FIG. 2 is formed between the ceramic substrate 10 and the cooling fin 40. The intermediate layer 50 includes a principal component metal layer 51 formed on a side of the cooling fin 40, and an active ingredient layer 52 formed on a side of the ceramic substrate 10.

The principal component metal layer 51 is formed using one of aluminum, nickel, copper, silver, and gold. The principal component metal layer 51 is stacked through a metallic bond with the cooling fin 40 on a surface different from a surface coming into contact with the active ingredient layer 52.

The active ingredient layer 52 is formed using one of titanium, zirconium, hafnium, germanium, boron, silicon, aluminum, chrome, indium, vanadium, molybdenum, tungsten, and manganese, or an oxide and hydride thereof. The active ingredient layer 52 is stacked through a covalent bond with the ceramic substrate 10 on a surface different from a surface coming into contact with the principal component metal layer 51.

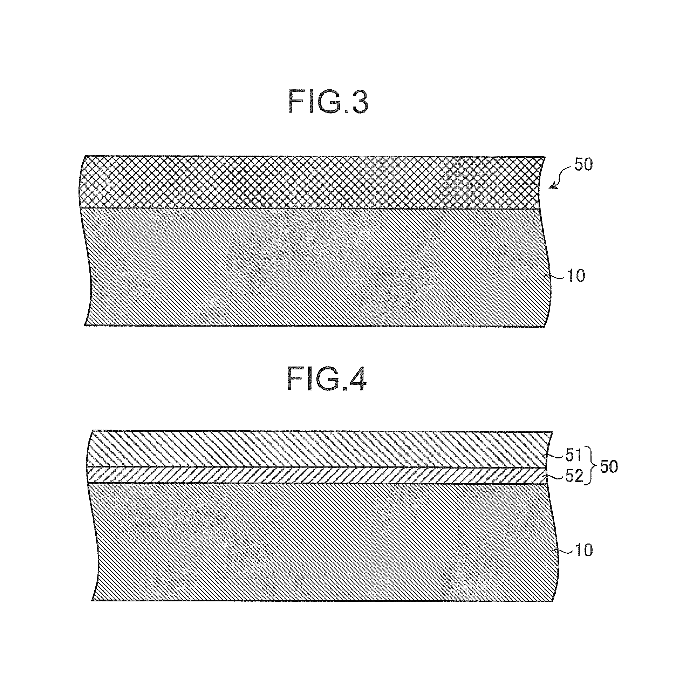

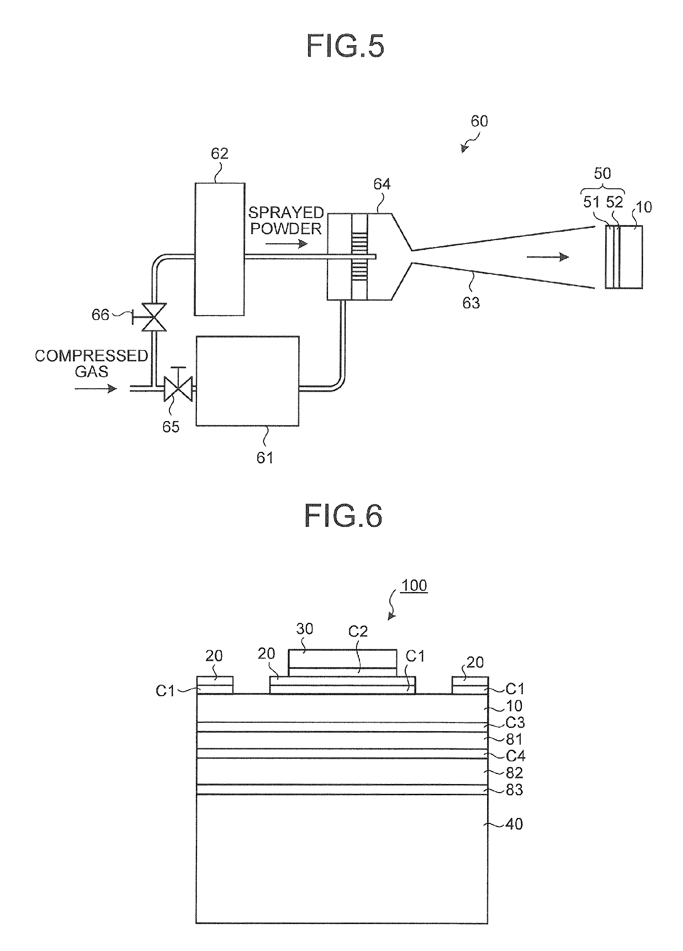

Next, a formation of the intermediate layer of the power module 1 is described with reference to FIGS. 3 to 5. FIGS. 3 and 4 are cross-sectional views schematically illustrating a formation of the intermediate layer in the power module. FIG. 5 is a schematic diagram illustrating an outline of a cold spray apparatus used for forming the metal coating.

First, as illustrated in FIG. 3, brazing filler metal used as the intermediate layer 50 is applied to a surface of the ceramic substrate 10 by a screen printing. Herein, the brazing filler metal contains metal or an alloy used as a principal component metal layer, metal or an oxide and hydride of metal used as an active ingredient layer, and the like, and is in a shape of a paste in which an organic solvent and an organic binder are mixed.

After the application of the brazing filler metal serving as the intermediate layer 50, the brazing filler metal is retained in a vacuum or in the atmosphere at 800 to 1000°C for an hour. After retained for an hour, the intermediate layer 50 is separated into the principal component metal layer 51 and the active ingredient layer 52 as illustrated in FIG. 4.

Herein, as for components in the brazing filler metal, referring to the principal component metal layer and the active ingredient layer retained in a vacuum, examples of a material used for the principal component metal layer include gold, silver, copper, aluminum, and nickel, and examples of a material used for the active ingredient layer include metal selected from titanium, zirconium, hafnium, and germanium, or a hydride thereof.

In addition, referring to the principal component metal layer and the active ingredient layer retained in the atmosphere, examples of a material used for the principal component metal layer include gold and silver, and examples of a material used for the active ingredient layer include one of titanium, zirconium, hafnium, germanium, boron, silicon, aluminum, chrome, indium, vanadium, molybdenum, tungsten, and manganese, or an oxide or hydride thereof.

Metal that is not oxidized even when dissolved in the atmosphere may be applied to the principal component metal layer retained in the atmosphere. In addition, a hydride, carbides, and a nitride of silicon, calcium, titanium, and zirconium may be used for the active ingredient layer retained in the atmosphere. Any combination of the principal component metal layer and the active ingredient layer described above may be applied. The principal component metal layer and the active ingredient layer contain at least one of the hydride, the oxide, and the metals mentioned above. In addition, an alloy mainly containing one of the metals mentioned above may be used.

Thereafter, the intermediate layer 50 is separated into the principal component metal layer 51 and the active ingredient layer 52, and a metal coating is formed using the cold spray method on an exposed surface of the principal component metal layer 51 in a state in which the principal component metal layer 51 is exposed to the outside. A formation of a coating using the cold spray method is performed by a cold spray apparatus 60 illustrated in FIG. 5.

The cold spray apparatus 60 includes a gas heater 61 that heats compressed gas, a powder supply device 62 that incorporates a powder material sprayed on a target spray object, and supplies the powder material to a spray gun 64, and a gas nozzle 63 that sprays material powder mixed with the heated compressed gas in the spray gun 64 to a substrate.

Helium, nitrogen, air, and the like are used as the compressed gas. The supplied compressed gas is supplied to the gas heater 61 and the powder supply device 62 by valves 65 and 66, respectively. Compressed gas supplied to the gas heater 61 is heated, for example, to 50 to 700°C, and then is supplied to the spray gun 64. More preferably, the compressed gas is heated so that an upper limit temperature of flame coating material powder sprayed on the principal component metal layer 51 of the intermediate layer 50 stacked on the ceramic substrate 10 is held at a melting point or less of a metallic material. When a heating temperature of a powder material is held at a melting point or less of a metallic material, an oxidation of a metallic material may be suppressed.

The compressed gas supplied to the powder supply device 62 supplies, for example, a predetermined discharge rate of material powder having a particle diameter of about 10 to 100 µm within the powder supply device 62 to the spray gun 64. The heated compressed gas becomes a supersonic flow (about 340 m/s or more) by the gas nozzle 63 in a shape of a convergent-divergent nozzle. The powder material supplied to the spray gun 64 is accelerated by being put in the supersonic flow of the compressed gas, and forms a coating by colliding with a substrate at a high speed in a solid state. Any device capable of forming a coating by causing material powder to collide with a substrate in a solid state may be used, and the invention is not limited to the cold spray apparatus 60 of FIG. 5.

The metal coating (cooling fin 40) illustrated in FIGS. 1 and 2 is formed by the cold spray apparatus 60 described above. Description has been made on the assumption that the brazing filler metal being used forms a shape of a paste in which the organic solvent and the organic binder are mixed. However, a shape of a foil may be formed when metal or an alloy used as the principal component metal layer, metal or an oxide and hydride of metal used as the active ingredient layer, and the like are contained.

According to the laminate related to the embodiment described above, it is possible to acquire a laminate having high adhesion strength when compared to a laminate acquired by a conventional cold spray method. In this way, it is possible to form a laminate having a thick metal coating. In addition, when an intermediate layer is formed on a ceramic substrate to be used, it is possible to expand a range of choice of a ceramic substrate to be used since a ceramic substrate may be used regardless of an oxide, a nitride, and a carbide.

In addition, when a metal coating is formed on a surface of a ceramic substrate in a conventional power module not using the cold spray method, a solder or a thermal compound is used to bond the surface of the ceramic substrate and the metal coating together. FIG. 6 is a schematic diagram illustrating an example of a configuration of a conventional power module not using the cold spray method. As illustrated in FIG. 6, a power module 100 includes the copper circuit 20 adhered to the ceramic substrate 10 which is an insulating substrate by an adhesion layer C1 such as a seal material, the chip 30 which is stacked on the copper circuit 20 and is fixed by a solder C2, a copper foil 81 which is formed in a metal coating such as aluminum and is adhered to a surface of the ceramic substrate 10, different from a surface where the copper circuit 20 is adhered, by a adhesion layer C3 such as a seal material, and the cooling fin 40 bonded to the ceramic substrate 10 through a solder C4, a copper substrate 82, and a thermal compound 83.

On the other hand, the laminate according to the invention may have a laminated structure of a simple configuration when compared to the conventional laminate illustrated in FIG. 6. In addition, even when a laminate has the same thickness, an area occupied by a principal component such as a cooling fin may be increased, and a range of design of a laminate may be widened.

The metal coating is described as a cooling fin that radiates heat generated from a chip. However, the metal coating may be provided to heat a component stacked on a ceramic substrate such as a chip through the metal coating.

In addition, description has been made on the assumption that the intermediate layer described above is provided between the ceramic substrate and the metal coating serving as the cooling fin. However, the intermediate layer may be provided between the ceramic substrate and the copper circuit.

### Examples

Herein, Examples of the invention will be described with reference to Table 1. It should be noted that the invention is not limited to Examples below.

**Table 1**

| | Substrate material | Intermediate layer | Metal coating | Heat treatment | Adhesion strength | Broken place |
|---|---|---|---|---|---|---|
| Example 1 | Al₂O₃ | Ag-30Cu-2TiH2 | Al | Vacuum 800°C/1hr | ≥60MPa | Adhesive |
| Example 2 | Al₂O₃ | Ag-30Cu-2TiH2 | Cu | Vacuum 800°C/1hr | ≥60MPa | Adhesive |
| Example 3 | Al₂O₃ | Ag-2Ge-15B | Cu | Atmosphere 850°C/1hr | ≥60MPa | Adhesive |
| Example 4 | Al₂O₃ | Ag-2TiH2-0.4Al | Cu | Atmosphere 970°C/1hr | ≥60MPa | Adhesive |
| Comparative Example 1 | Al₂O₃ | No intermediate layer | Al | No | - | After formation Separation between substrate and coating |
| Comparative Example 2 | Al₂O₃ | No intermediate layer | Cu | No | - | After formation Separation between substrate and coating |
| Comparative Example 3 | Al₂O₃ | Ag | Cu | Atmosphere 850°C/1hr | - | After formation Separation between substrate and coating |

### (Example 1)

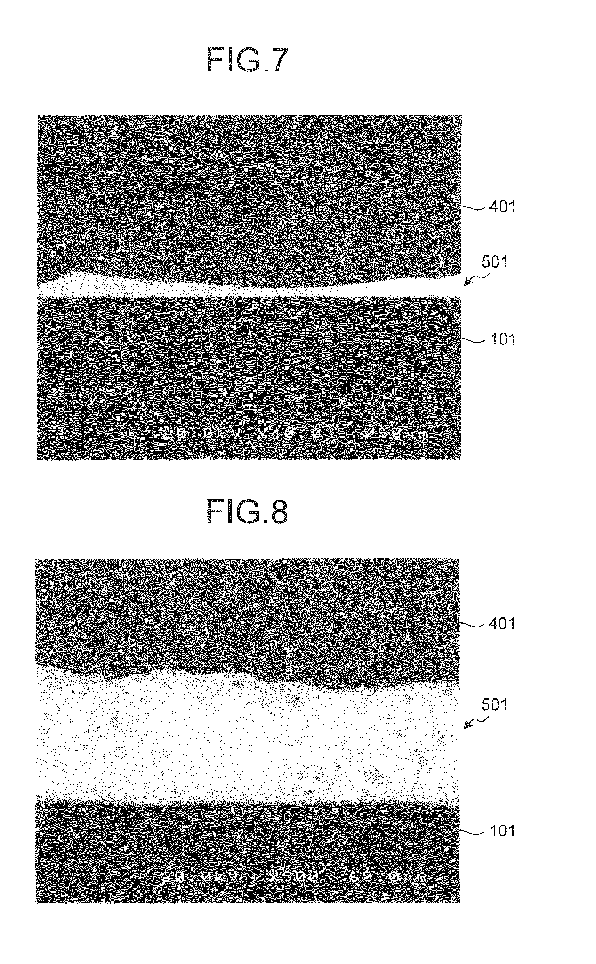

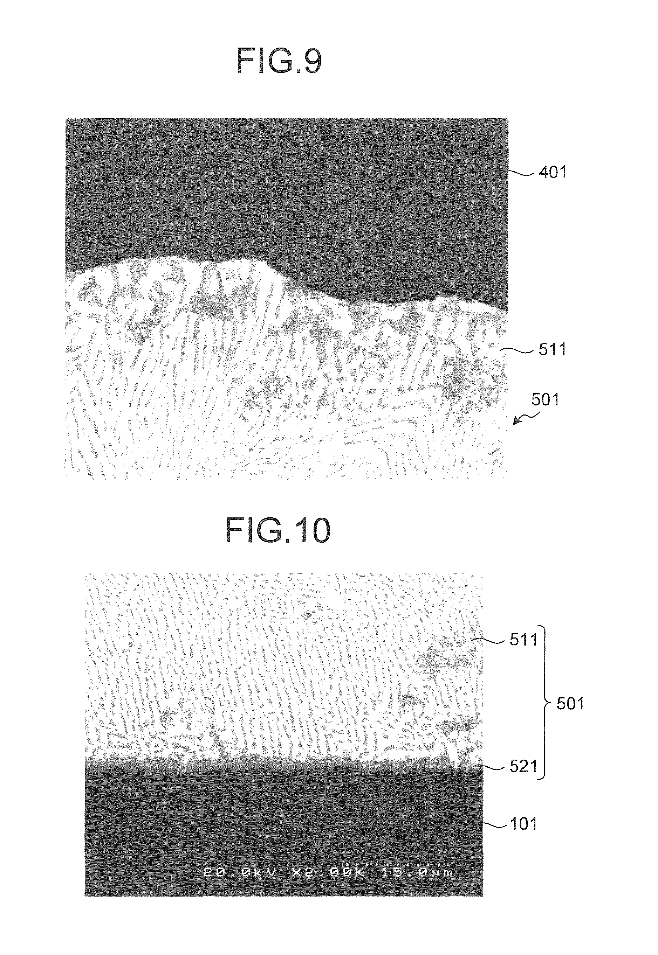

In Example 1, a laminate is fabricated using a silver-copper alloy for a principal component metal layer 511 and titanium hydride for an active ingredient layer 521 as an intermediate layer 501. In addition, alumina is used for a ceramic substrate 101, and aluminum is used for a metal coating 401. A cross-section backscattered electron image of the laminate is illustrated in FIGS. 7 to 10. The cross-section backscattered electron image of FIG. 7 is a 40-time electron image, the cross-section backscattered electron image of FIG. 8 is a 500-time electron image, and the cross-section backscattered electron images of FIGS. 9 and 10 are 2000-time electron images. The principal component metal layer 511 and the active ingredient layer 521 of the intermediate layer 501 are formed by applying brazing filler metal, and then retaining the brazing filler metal in a vacuum at 800°C for an hour.

As illustrated in FIGS. 7 to 10, a bonded state is maintained among the intermediate layer 501, the ceramic substrate 101, and the metal coating 401 without being separated from one another. In addition, as illustrated in FIGS. 9 and 10, referring to the intermediate layer 501, the principal component metal layer 511 is formed on a side of the metal coating 401, and the active ingredient layer 521 is formed on a side of the ceramic substrate 101.

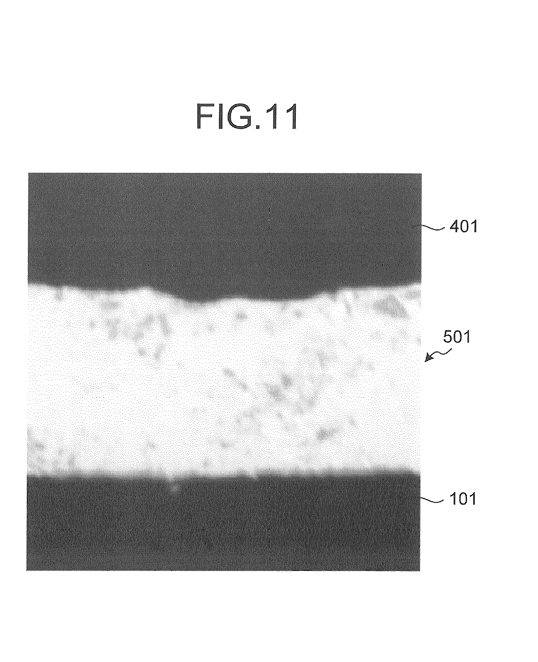

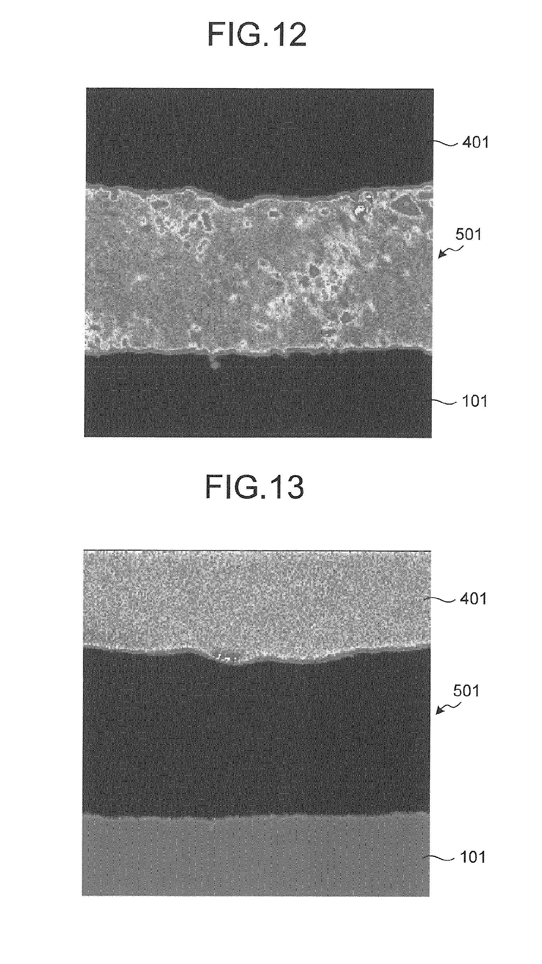

Further, in Example 1, an element distribution is verified for the ceramic substrate 101, the metal coating 401, and the intermediate layer 501 containing the element, respectively. FIG. 11 is a diagram illustrating a cross-section backscattered electron image (500 times) performing an elemental analysis. In addition, FIGS. 12 to 16 are diagrams illustrating a result of cross-section element distribution analysis of the cross-section backscattered electron image illustrated in FIG. 11. The result of cross-section element distribution analysis illustrated in FIGS. 12 to 16 is displayed in red when element content to be analyzed increases, and is displayed in blue when the contained amount decreases. That is, a more reddish color is displayed for larger content.

FIG. 12 is a result of cross-section element distribution analysis illustrating silver content. Silver is used as a silver-copper alloy in the principal component metal layer 511, and the intermediate layer 501 is displayed in red.

FIG. 13 is a result of cross-section element distribution analysis illustrating aluminum content. Aluminum is used in the metal coating 401, and is contained in alumina (aluminum oxide) in the ceramic substrate 101. For this reason, in FIG. 13, the metal coating 401 is displayed in red, and the ceramic substrate 101 is displayed in green.

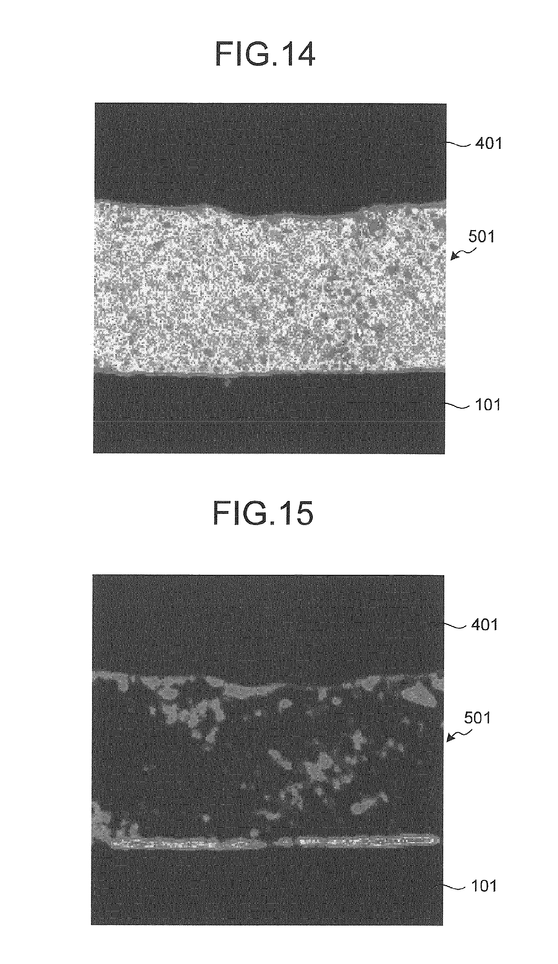

FIG. 14 is a result of cross-section element distribution analysis illustrating copper content. Copper is used as a silver-copper alloy in the principal component metal layer 511, and the intermediate layer 501 is displayed in yellow (partially red).

FIG. 15 is a result of cross-section element distribution analysis illustrating titanium content. Titanium is used as the active ingredient layer 521, and the intermediate layer 501 on a side of the ceramic substrate 101 is displayed in red.

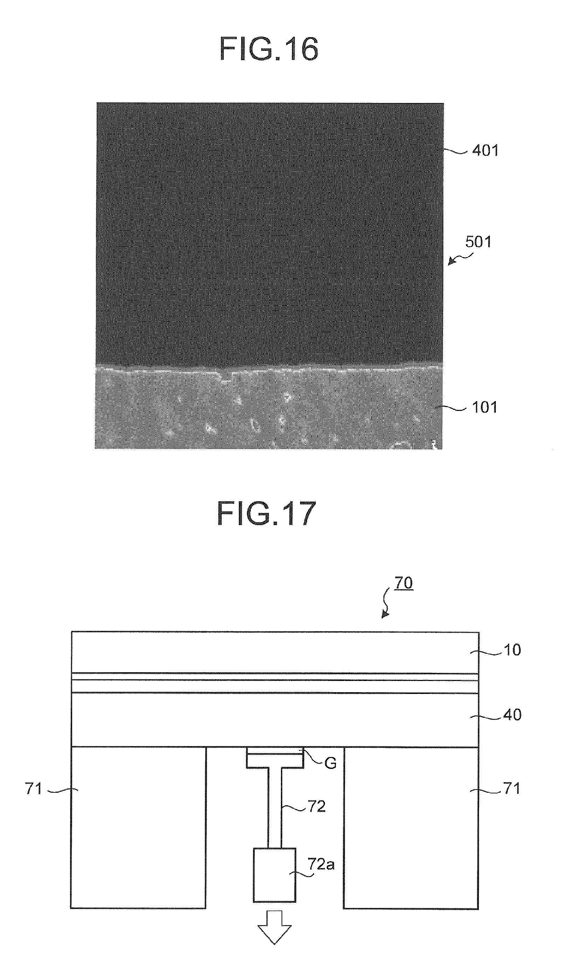

FIG. 16 is a result of cross-section element distribution analysis illustrating oxygen content. Oxygen is contained in alumina (aluminum oxide) of the ceramic substrate 101, and the ceramic substrate 101 is displayed in red.

In addition, an adhesion strength evaluation is performed on a laminate according to Example 1. FIG. 17 is a schematic diagram illustrating a schematic configuration of an evaluation apparatus performing an adhesion strength evaluation. An evaluation apparatus 70 illustrated in FIG. 17 includes a stage 71 on which a laminate (Examples 1 to 4, and Comparative Examples 1 to 3) including at least a ceramic substrate 10 and a cooling fin 40 corresponding to a metal coating are placed, and a pin 72 applying a force downward in the drawing to the laminate.

The pin 72 is made of aluminum, and is adhered to the laminate by solidifying an adhesive G which is epoxy resin. The adhesive G is hardened by being retained at 150°C for an hour. Thereafter, adhesion strength between the ceramic substrate and the metal coating is evaluated by pulling a distal end 72a of the pin 72 in a direction of being separated from the laminate. An evaluation result of the adhesion strength evaluation is shown in Table 1.

When tensile stress of 60 MPa is applied in the laminate according to Example 1, the adhesive G is broken, and the pin 72 is separated from the laminate according to Example 1. In the test, when the adhesive G is separated from the metal coating by verifying a broken place after the evaluation test, the adhesive strength is 60 MPa or more. In this way, a result is obtained in which adhesion strength between the ceramic substrate and the metal coating is 60 MPa or more, which is high adhesion strength for a laminate.

### (Example 2)

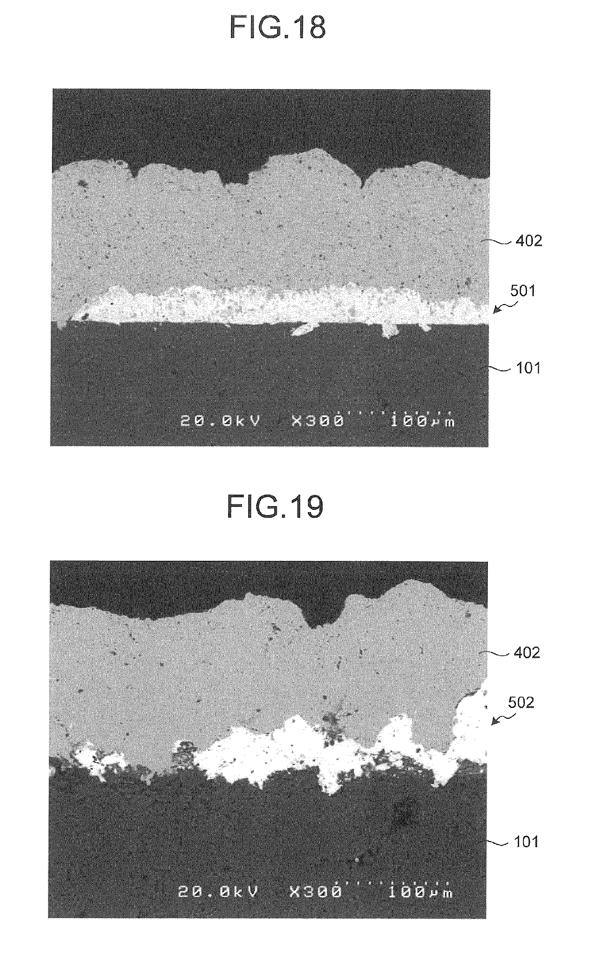

In Example 2, the laminate is fabricated using a silver-copper alloy for the principal component metal layer 511 and titanium hydride for the active ingredient layer 521 as the intermediate layer 501. In addition, alumina is used as the ceramic substrate 101, and copper is used as a metal coating 402. A cross-section backscattered electron image (300 times) of the laminate is illustrated in FIG. 18. The principal component metal layer 511 and the active ingredient layer 521 of the intermediate layer 501 are formed by applying brazing filler metal, and then retaining the brazing filler metal in a vacuum at 800°C for an hour.

As illustrated in FIG. 18, a bonded state is maintained among the intermediate layer 501, the ceramic substrate 101, and the metal coating 402 without being separated from one another. Even when the meal coating is copper instead of aluminum, a laminate maintaining a bonded state is obtained.

In addition, an adhesion strength evaluation is performed by the evaluation apparatus 70 illustrated in FIG. 17 for the laminate according to Example 2. From the adhesion strength evaluation described above, a result is obtained in which adhesion strength between the ceramic substrate and the metal coating is 60 MPa or more, which is high adhesion strength for a laminate.

### (Example 3)

In Example 3, the laminate is fabricated by using silver for the principal component metal layer, and germanium of 2% by weight for the active ingredient layer as an intermediate layer 502, and adding boron of 15% by weight. In addition, alumina is used as the ceramic substrate 101, and copper is used as the metal coating 402. A cross-section backscattered electron image (300 times) of the laminate is illustrated in FIG. 19. The principal component metal layer and the active ingredient layer of the intermediate layer 502 are formed by applying brazing filler metal, and then retaining the brazing filler metal in the atmosphere at 850°C for an hour.

As illustrated in FIG. 19, a bonded state is maintained among the intermediate layer 502, the ceramic substrate 101, and the metal coating 402 without being separated from one another. Even when the intermediate layer 502 is formed in the atmosphere, a laminate maintaining a bonded state is obtained.

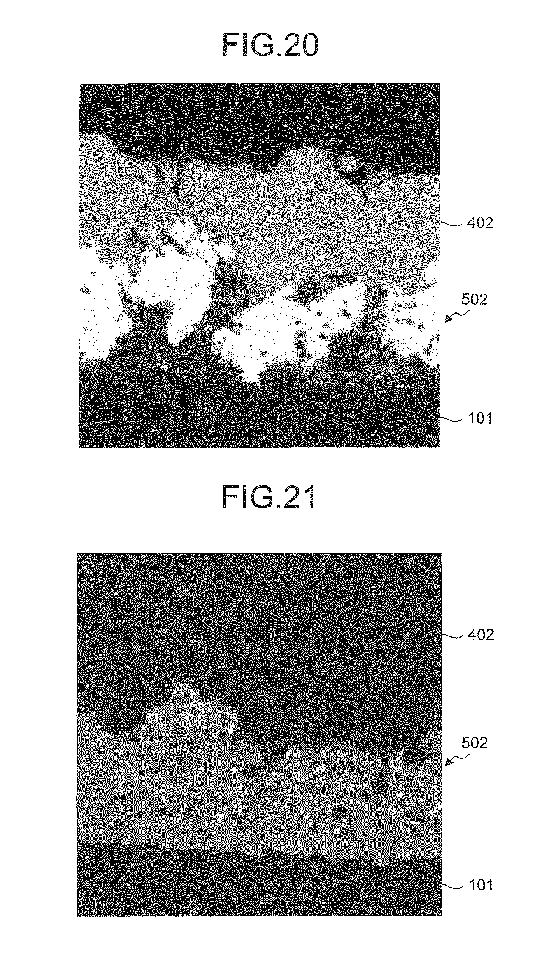

Further, an element distribution is verified for the ceramic substrate 101, the metal coating 402, and the intermediate layer 502 containing the element, respectively. FIG. 20 illustrates a cross-section backscattered electron image (500 times) on which an elemental analysis has been performed. In addition, FIGS. 21 to 25 are diagrams illustrating a result of cross-section element distribution analysis of the cross-section backscattered electron image illustrated in FIG. 20. The result of cross-section element distribution analysis illustrated in FIGS. 21 to 25 is displayed in red when element content to be analyzed increases, and is displayed in blue when the content decreases. That is, a color changes from blue to a reddish color as content increases.

FIG. 21 is a result of cross-section element distribution analysis illustrating silver content. Silver is used as the principal component metal layer, and the intermediate layer 502 is displayed in red.

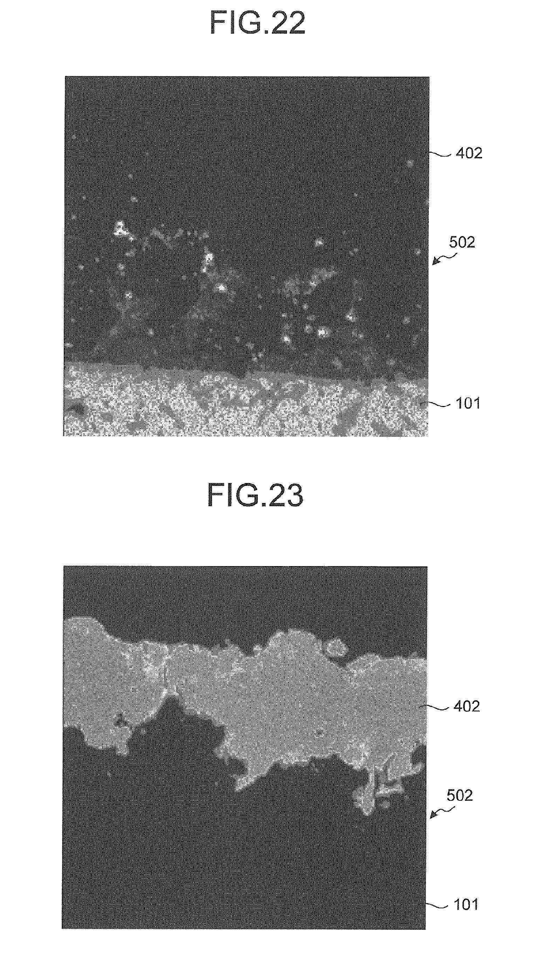

FIG. 22 is a result of cross-section element distribution analysis illustrating aluminum content. Aluminum is contained in alumina (aluminum oxide) in the ceramic substrate 101, and the ceramic substrate 101 is displayed in green or yellow.

FIG. 23 is a result of cross-section element distribution analysis illustrating copper content. Copper is used as the metal coating 402, and the metal coating 402 is displayed in red.

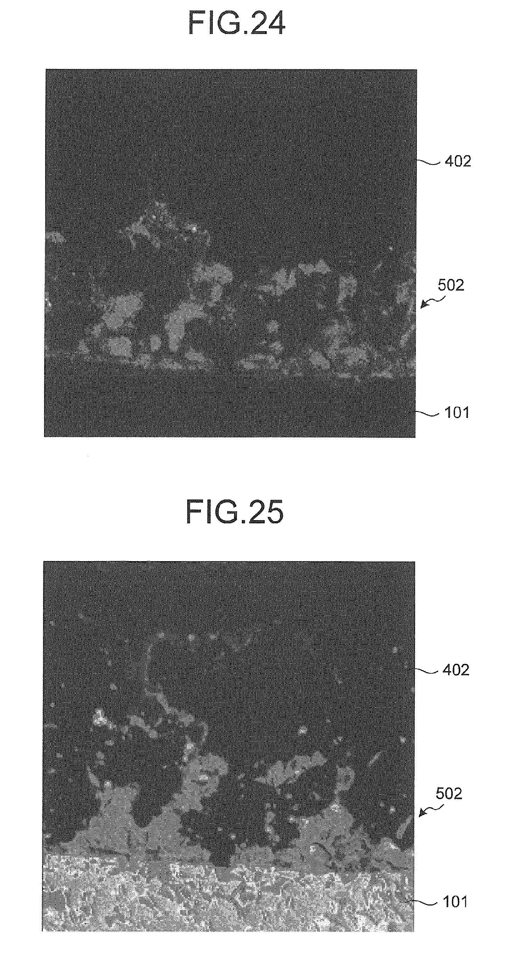

FIG. 24 is a result of cross-section element distribution analysis illustrating germanium content. Germanium is used as the active ingredient layer, and the intermediate layer 502 on a side of the ceramic substrate 101 is displayed in green. In the intermediate layer 502 of Example 3, the added boron may be contained in the active ingredient layer.

FIG. 25 is a result of cross-section element distribution analysis illustrating oxygen content. Oxygen is contained in aluminum (aluminum oxide) of the ceramic substrate 101, and the ceramic substrate 101 is displayed in red. In addition, since the intermediate layer 502 is formed in the atmosphere in Example 3, an oxidized metal portion in the intermediate layer 502 is displayed in green.

In addition, an adhesion strength evaluation is performed by the evaluation apparatus 70 illustrated in FIG. 17 for the laminate according to Example 3. From the adhesion strength evaluation described above, a result is obtained in which adhesion strength between the ceramic substrate and the metal coating is 60 MPa or more, which is high adhesion strength for a laminate.

### (Example 4)

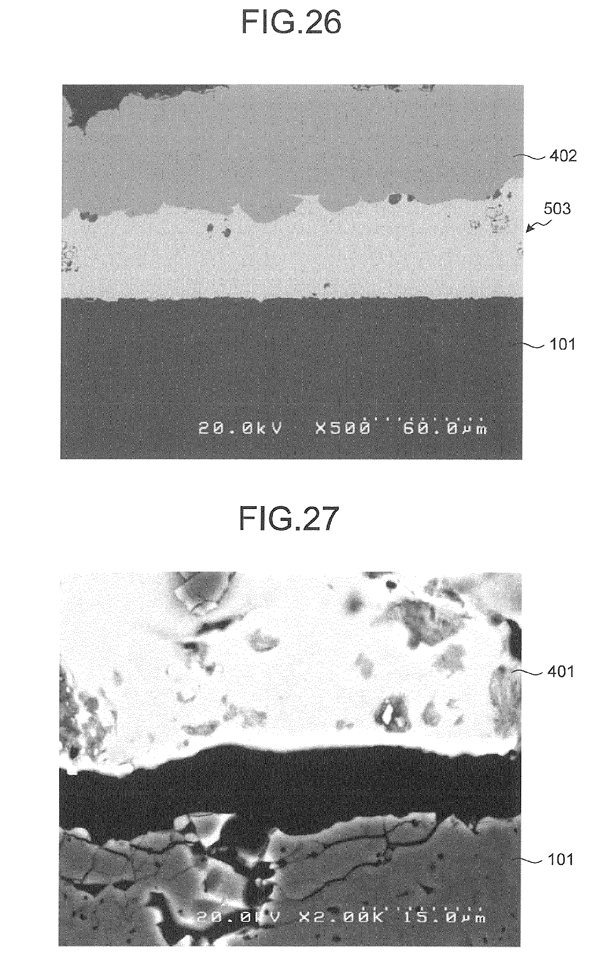

In Example 4, the laminate is fabricated by using silver for the principal component metal layer, and titanium hydride of 2% by weight for the active ingredient layer as an intermediate layer 503, and adding aluminum of 0.4% by weight. In addition, alumina is used as the ceramic substrate 101, and copper is used as the metal coating 402. A cross-section backscattered electron image (500 times) of the laminate is illustrated in FIG. 26. The principal component metal layer 511 and the active ingredient layer 521 of the intermediate layer 503 are formed by applying brazing filler metal, and then retaining the brazing filler metal in the atmosphere at 970°C for an hour.

As illustrated in FIG. 26, a bonded state is maintained among the intermediate layer 503, the ceramic substrate 101, and the metal coating 402 without being separated from one another. A laminate maintaining a bonded state is obtained even when the metal coating is copper instead of aluminum, and the intermediate layer is formed in the atmosphere.

In addition, an adhesion strength evaluation is performed by the evaluation apparatus 70 illustrated in FIG. 17 for the laminate according to Example 4. From the adhesion strength evaluation described above, a result is obtained in which adhesion strength between the ceramic substrate and the metal coating is 60 MPa or more, which is high adhesion strength for a laminate.

### (Comparative Example 1)

As Comparative Example for Example 1, a laminate is fabricated by forming a film of aluminum serving as the metal coating 401 by the cold spray method on alumina serving as the ceramic substrate 101 without forming the intermediate layer. A cross-section backscattered electron image (2,000 times) of the laminate is illustrated in FIG. 27.

As illustrated in FIG. 27, when aluminum is directly formed as a film on the ceramic substrate 101 by the cold spray method, the ceramic substrate 101 and the metal coating 401 are separated from each other.

### (Comparative Example 2)

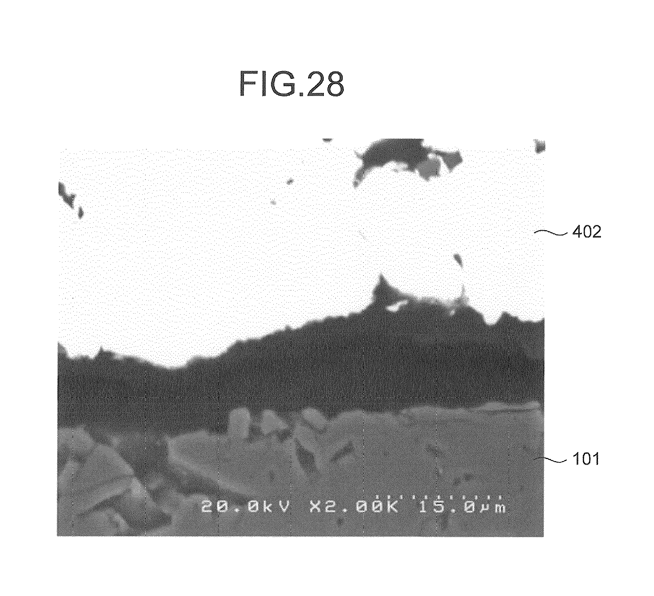

As Comparative Example for Example 2, a laminate is fabricated by forming a film of copper serving as the metal coating 402 by the cold spray method on alumina serving as the ceramic substrate 101 without forming the intermediate layer. A cross-section backscattered electron image (2,000 times) of the laminate is illustrated in FIG. 28.

As illustrated in FIG. 28, when copper is directly formed as a film on the ceramic substrate 101 by the cold spray method, the ceramic substrate 101 and the metal coating 402 are separated from each other.

### (Comparative Example 3)

As Comparative Example for Examples 3 and 4, a laminate is fabricated by forming an intermediate layer using silver in the atmosphere (850°C, for an hour) on alumina serving as the ceramic substrate, and then forming a film of copper serving as the metal coating by the cold spray method. The Comparative Example 3 has a configuration in which the active ingredient layer is not included in the intermediate layer.

When copper is formed as a film by the cold spray method on the ceramic substrate where silver is formed as an intermediate layer, the ceramic substrate and the metal coating (silver serving as the intermediate layer) are separated from each other.

### Industrial Applicability

As described in the foregoing, the laminate and the method of manufacturing the laminate according to the invention are useful to bond a ceramic substrate and a metal coating together.

### Reference Signs List

- 1, 100: POWER MODULE
- 10, 101: CERAMIC SUBSTRATE
- 20: COPPER CIRCUIT
- 30: CHIP
- 40, 401, 402: COOLING FIN (METAL COATING)
- 50, 501, 502, 503: INTERMEDIATE LAYER
- 51, 511: PRINCIPAL COMPONENT METAL LAYER
- 52, 521: ACTIVE INGREDIENT LAYER
- 60: COLD SPRAY APPARATUS
- 61: GAS HEATER
- 62: POWDER SUPPLY DEVICE
- 63: GAS NOZZLE
- 64: SPRAY GUN
- 70: EVALUATION APPARATUS
- 71: STAGE
- 72: PIN

## Claims

1. A laminate comprising:
an insulating ceramic substrate;
an intermediate layer formed on a surface of the ceramic substrate and comprising a principal component metal layer containing metal and an active ingredient layer including metal, a metal oxide, or a metal hydride; and
a metal coating formed on a surface of the intermediate layer by accelerating a metal-containing powder with gas, and depositing the same on the surface thereof by spraying while in a solid state.

2. The laminate according to claim 1, wherein the intermediate layer is formed by a heat treatment in a vacuum.

3. The laminate according to claim 2, wherein the active ingredient layer contains at least one selected from a group consisting of one of metals of titanium, zirconium, hafnium, and germanium, or a metal hydride.

4. The laminate according to claim 2 or 3, wherein the principal component metal layer contains at least one selected from a group consisting of gold, silver, copper, aluminum, and nickel.

5. The laminate according to claim 1, wherein the intermediate layer is formed by a heat treatment in the atmosphere.

6. The laminate according to claim 5, wherein the active ingredient layer contains at least one selected from a group consisting of titanium, zirconium, hafnium, germanium, boron, silicon, aluminum, chrome, indium, a metal oxide, and a metal hydride.

7. The laminate according to claim 5 or 6, wherein the principal component metal layer contains at least one of gold and silver.

8. A method of manufacturing a laminate in which a metal coating is formed on a surface of a ceramic substrate, the method comprising:
a brazing filler metal disposing step of disposing brazing filler metal containing metal, or a metal oxide or hydride on the surface of the ceramic substrate;
an intermediate layer forming step of forming an intermediate layer by performing a heat treatment on the ceramic substrate where the brazing filler metal is disposed in the brazing filler metal disposing step; and
a metal coating forming step of forming a metal coating on a surface of the intermediate layer, which is formed by the intermediate layer forming step, by accelerating a metal-containing powder with gas, and depositing the same on the surface thereof by spraying while in a solid state.

9. The method according to claim 8, wherein the intermediate layer forming step is performed in a vacuum.

10. The method according to claim 8, wherein the intermediate layer forming step is performed in the atmosphere.
